# EUROPEAN PATENT APPLICATION

(11) **EP 4 293 275 A1**
(43) Date of publication of application: **20.12.2023**
(21) Application number: 22752974.0
(22) Date of filing: 09.02.2022
(51) Int. Cl.: F21K 9/20, H01L 33/60, H01L 33/48, H01L 33/52, H01L 25/13, F21K 9/60, F21Y 115/10

(54) **LIGHT-EMITTING ELEMENT PACKAGE AND LIGHTING DEVICE COMPRISING SAME**

(30) Priority: 09.02.2021 KR 20210018515
(71) Applicant: LG Innotek Co., Ltd., Seoul 07796 (KR)
(72) Inventor: CHOI, Young Jae, Seoul 07796 (KR); PARK, Moo Ryong, Seoul 07796 (KR)
(74) Representative: M. Zardi & Co S.A.
(86) International application number: PCT/KR2022/001968
(87) International publication number: WO 2022/173214

(57) **Abstract**

The lighting device disclosed in the embodiment of the invention; a circuit board; a plurality of light emitting device packages disposed on the circuit board; a resin layer covering the plurality of light emitting device packages; and a layer for diffusing or reflecting light on the resin layer, wherein each light emitting device package includes a first side portion facing the circuit board, a second side portion opposite to the first side portion, third and fourth side portions on both sides of the first and second side portions, a cavity in which a part of a front side portion is opened; a plurality of lead frames each having a plurality of frames disposed on the bottom of the cavity and a bonding portion bent from each of the plurality of frames to a first side portion; and a plurality of light emitting chips electrically connected to the plurality of frames on the bottom of the cavity, and the cavity may have the same length as the length of the body in the first direction.

## Description

### [Technical Field]

An embodiment of the invention relates to a light emitting device package and a lighting device having the same.

### [Background Art]

The light emitting device package may be, for example, a device having a light emitting diode, and the light emitting diode is a semiconductor device that converts electrical energy into light, and is in the limelight as a next-generation light source replacing fluorescent lamps and incandescent lamps. Since the light emitting diode generates light using a semiconductor device, it consumes very low power compared to an incandescent lamp that generates light by heating tungsten or a fluorescent lamp that generates light by colliding ultraviolet rays generated through high-voltage discharge with a phosphor. Since the light emitting diode generates light using a semiconductor device, it has a longer lifespan, faster response characteristics, and eco-friendly characteristics than conventional light sources. In addition, light emitting diodes are used in lighting devices such as various lamps used indoors or outdoors, liquid crystal display devices, electric signboards, vehicle lighting, or street lights.

### [Disclosure]

### [Technical Problem]

An embodiment of the invention provides a side-view type light emitting device package capable of multi-sided light emission and a lighting device having the same. An embodiment of the invention provides a side-view type light emitting device package that emits light through two adjacent side surfaces and a lighting device having the same. An embodiment of the invention provides a lighting device having a member disposed above a light emitting device package and blocking light emitted through a front surface and both side surfaces of the light emitting device package. An embodiment of the invention provides a lighting device that provides surface light by light emitted through the front surface and both side surfaces of a light emitting device package.

### [Technical Solution]

A lighting device disclosed in an embodiment of the invention includes a circuit board; a plurality of light emitting device packages disposed on the circuit board; a resin layer covering the plurality of light emitting device packages; and a layer that diffuses or reflects light on the resin layer, wherein each of the light emitting device packages includes a body having a first side portion facing the circuit board, a second side portion opposite to the first side portion, third and fourth side portions on both sides of the first and second side portions, and a cavity in which a part of a front side portion is opened; a plurality of lead frames each having a plurality of frames disposed on a bottom of the cavity and a plurality of bonding portions bent from each of the plurality of frames toward the first side portion; and a plurality of light emitting chips electrically connected to the plurality of frames on the bottom of the cavity, wherein the third and fourth side portions of the body are disposed in a first direction of the body, and the front and rear side portions of the body are disposed on both sides of a second direction perpendicular to the first direction, and the cavity may have the same length as the length of the body in the first direction.

According to an embodiment of the invention, the cavity includes a first bottom supporting portion disposed on any one frame adjacent to the third side portion and a second bottom supporting portion disposed on any other frame adjacent to the fourth side portion, and the first and second bottom supporting portions may be disposed concavely from the front side portion on both bottoms of the cavity in the first direction.

According to an embodiment of the invention, a molding member is included in the cavity, and a length of the molding member may be the same as the length of the cavity in the first direction. The molding member may be exposed to the front and third and fourth side portions of the body, respectively.

According to an embodiment of the invention, a diffusion layer for diffusing light on the resin layer, and a light transmitting layer and a light blocking portion between the resin layer and the diffusion layer may be included, and the light blocking portion may vertically overlap the light emitting device package. The light blocking portion may cover a front of the light emitting device package, and the light blocking portion may include first and second sub-light blocking portions covering third and fourth side portions of the body of the light emitting device package. The first and second sub-light blocking portions may be spaced apart from each other in the first direction, and may further extend to both sides in the first direction and rearward in the second direction than the third and fourth side portions of the light emitting device package.

According to an embodiment of the invention, a diffusion layer disposed on the resin layer, and a light blocking portion having an optical pattern portion between the resin layer and the diffusion layer may be included, wherein the optical pattern portion of the light blocking portion may have a plurality of concave portions vertically overlapping the light emitting device package.

According to an embodiment of the invention, a first reflective layer for reflecting light is included on the resin layer, and the circuit board, the resin layer, and the first reflective layer may include a plurality of convex surfaces protruding with a convex curved surface on the front side portion of the light emitting device package.

According to an embodiment of the invention, the lead frame includes a first lead frame, and second and third lead frames on both sides of the first lead frame, and the light emitting chip
may include a plurality of light emitting chips mounted in a flip form on each of the frames of the first, second, and third lead frames, and the frame of the first lead frame may include a groove region in which a top layer is removed between the plurality of light emitting chips.

A lighting device according to an embodiment of the invention includes a circuit board; and a plurality of light emitting device packages disposed on the circuit board, wherein each of the light emitting device packages includes a body having a first side portion facing the circuit board, a second side portion opposite to the first side portion, third and fourth side portions on both sides of the first and second side portions, and a cavity in which a part of a front side portion is opened; a plurality of lead frames each having a plurality of frames disposed on a bottom of the cavity and a plurality of bonding portions bent from each of the plurality of frames to the first side portion; a plurality of light emitting chips electrically connected to the plurality of frames on the bottom of the cavity; and a molding member within the cavity, wherein the third and fourth side portions of the body are disposed in a first direction of the body, and the front and rear side portions of the body are disposed on both sides of the second direction orthogonal to the first direction. The cavity may have the same length as the body in the first direction, and the molding member may have the same length as the cavity in the first direction.

According to an embodiment of the invention, the cavity includes a first bottom supporting portion disposed on any one frame adjacent to the third side portion and a second bottom supporting portion disposed on any other frame adjacent to the fourth side portion. The first and second bottom supporting portions may be concavely disposed on bottoms of both sides of the cavity in the first direction from the front side portion, and may come into contact with the molding member.

### [Advantageous Effects]

An embodiment of the invention may improve light extraction efficiency and heat dissipation efficiency in a light emitting device package. An embodiment of the invention may improve the uniformity of surface light by using the light emitted from the light emitting device package, and may improve the luminous flux of the light emitting device package and a lighting device including the same. An embodiment of the invention may improve the reliability of a light emitting device package and a lighting device having the same.

### [Description of Drawings]

FIG. 1 is a plan view showing a light emitting device package according to a first embodiment of the invention.
FIG. 2 is an A-A cross-sectional view of the light emitting device package of FIG. 1.
FIG. 3 is an example of a bottom view of the light emitting device package of FIG. 1.
FIG. 4 is an example of a lighting module in which the light emitting device package of FIG. 1 is disposed on a circuit board.
FIG. 5 is another side view of the lighting module of FIG. 4.
FIG. 6 is a plan view illustrating an example of a lighting device having the light emitting device package of FIG. 1.
FIG. 7 is a view for explaining the shape and light distribution of the light blocking portion in the lighting device of FIG. 6.
FIG. 8 is a C-C cross-sectional view of the lighting device of FIG. 6.
FIG. 9 is a modified example of a light blocking portion in the lighting device of FIG. 6.
FIG. 10 is a plan view illustrating another example of a lighting device having the light emitting device package of FIG. 1.
FIG. 11 is a side cross-sectional view of the lighting device of FIG. 10.
FIG. 12 is a diagram illustrating light distribution according to the shape of a convex portion of the lighting device of FIG. 10.
FIG. 13 is a plan view of a vehicle to which a lamp having a lighting device or a lighting module according to an embodiment of the invention is applied.
FIG. 14 is a diagram illustrating a lamp having the lighting module or lighting device of FIG. 13.

### [Best Mode]

Hereinafter, a preferred embodiment in which a person skilled in the art can easily practice the invention will be described in detail with reference to the accompanying drawings. However, it should be understood that the embodiments described in this specification and the configurations shown in the drawings are only one preferred embodiment of the invention, and there may be various equivalents and modifications that may replace them at the time of this application. In describing the operating principle of the preferred embodiment of the invention in detail, if it is determined that a detailed description of a related known function or configuration may unnecessarily obscure the subject matter of the invention, the detailed description will be omitted.
Terms to be described later are terms defined in consideration of functions in the invention, and the meaning of each term should be interpreted based on the contents throughout this specification. The same reference numerals are used throughout the drawings for parts having similar functions and actions. Since the embodiments and the configurations illustrated in the drawings are preferred embodiments of the present invention and do not represent all of the technical ideas of the present invention, there may be various equivalents and modifications that may replace them at the time of the present application. Hereinafter, embodiments will be clearly revealed through the accompanying drawings and description of the embodiments. In the description of the embodiments, when each layer (film), area, pattern, or structure is described as being formed on or under the substrate, each layer (film), region, pad, or pattern, "on" and "under" include both "directly" or "directly" through other layers. In addition, the criterion for the top or bottom of each layer will be described based on the drawings. Throughout this specification, "frontward" or "front" and "rearward" or "rear" refer to the direction in which the package is viewed from the Y direction, and "left side" and "right side" refer to the direction in which the package is viewed from the X direction, The upward direction and the downward direction may be directions in which the package is viewed from the Z direction.

Hereinafter, a light emitting device package according to an embodiment of the invention, a lighting module and a lighting device having the light emitting device package will be described with reference to the accompanying drawings.

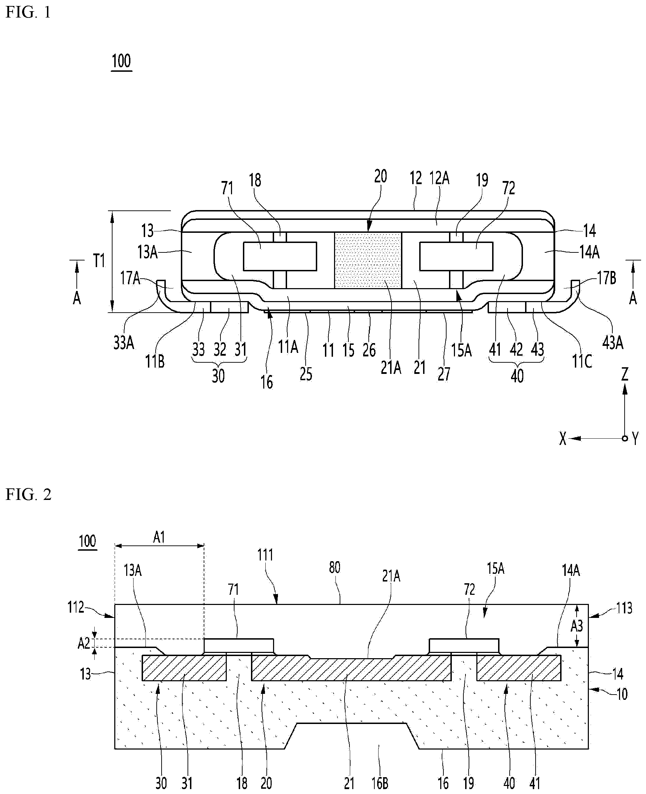

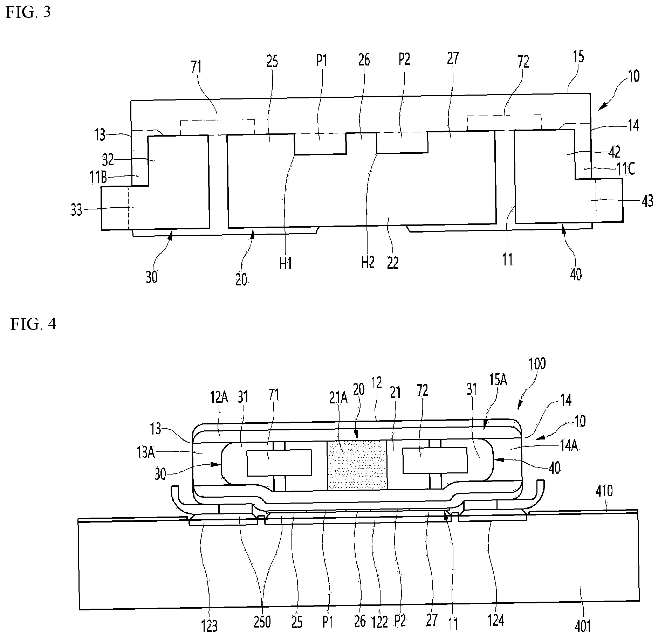

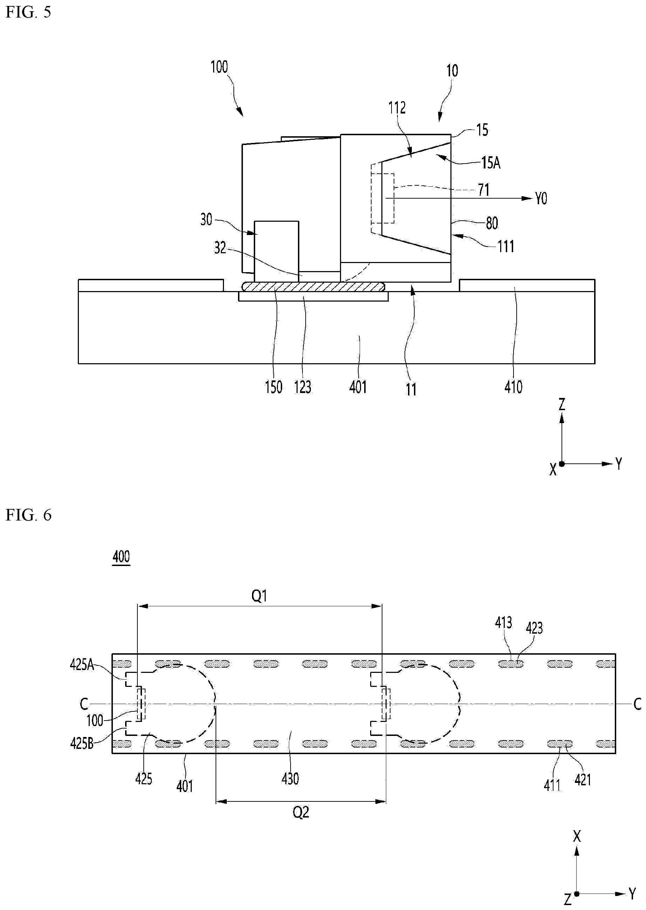

FIG. 1 is a plan view showing a light emitting device package according to a first embodiment of the invention, FIG. 2 is an A-A cross-sectional view of the light emitting device package of FIG. 1, FIG. 3 is an example of a bottom view of the light emitting device package of FIG. 1, FIG. 4 is an example of a lighting module in which the light emitting device package of FIG. 1 is disposed on a circuit board, and FIG. 5 is another side view of the lighting module of FIG. 4.

Referring to FIGS. 1 to 3, the light emitting device package 100 according to the embodiment of the invention includes a body 10 having a cavity 15A, a plurality of lead frames 20, 30, and 40, and light emitting chips 71 and 72 disposed on at least one of the plurality of lead frames 20, 30, and 40. The light emitting device package 100 may be implemented as a side-view type package, and may be applied to a mobile phone, a portable computer, various lighting fields, vehicle lamps, or pointing devices. For convenience of explanation, in the light emitting device package 100, the first direction is the X direction or the length direction of the package, the second direction is the Y direction or the width direction of the package, and the third direction may be the Z direction or the thickness direction of the package.

In the light emitting device package 100, one direction is a package having a length longer than a length of the other direction, for example, the length of the body 10 in the first direction X may be two times the thickness T1 of the body 10 in the third direction Z, for example, in a range from 2 times to 4.5 times. The length of the body 10 in the first direction X may be twice or more than the lengths in each of the second and third directions. The length of the body 10 in the first direction X may be 3 mm or more, for example, in the range of 3 mm to 7 mm or in the range of 4.5 mm to 6 mm. The thickness T1 of the light emitting device package 100 may be 1.5 mm or less, for example, in the range of 0.6 mm to 1.5 mm. Since the light emitting device package 100 may have a relatively thin thickness T1, the thickness of a lighting module or lamp having the light emitting device package 100 may be reduced. The thickness T1 of the light emitting device package 100 may be equal to or greater than the thickness of the body 10.

Since the body 10 provides a long length in the first direction X, an area of the emission side or a light emitting area of the cavity 15A may be increased in the first direction X more than in other directions. In addition, since the light emitting area of the cavity 15A increases in the first direction X, each of the light emitting chips 71 and 72 may have a length (e.g., length in the X direction) greater than a width (e.g., length in the Z direction), and it may be provided, for example, in a rectangular shape. Each of the light emitting chips 71 and 72 may have a length twice or more, for example, two to three times the width. Since the light emitting device package 100 is provided as a package having a thin body 10 and a long length in the first direction, it is possible to provide a smaller thickness of the light emitting module as shown in FIGS. 5 and 6, and may provide a greater light beam angle in the first direction X. The light emitting device package 100 provides a long length in the first direction X, so that when the plurality of light emitting chips 71 and 72 are arranged in the first direction, the number of light emitting chips 71 and 72 arranged may increase.

The body 10 may be coupled with a plurality of lead frames 20, 30, and 40. The body 10 may be formed of an insulating material. The body 10 may be formed of a reflective material. The body 10 may be formed of a material having higher reflectance than transmittance for wavelengths emitted from the light emitting chips 71 and 72. The body 10 may be formed of a resin-based insulating material, such as polyphthalamide (PPA), silicone-based, epoxy-based, thermosetting resin including plastic materials, or a material with high heat resistance and high light resistance. The body 10 includes a white-based resin. The body 10 may include a reflective material, for example, a resin material to which a metal oxide is added, and the metal oxide may include at least one of TiO₂, SiO₂, and Al₂O₃. This body 10 may effectively reflect incident light. As another example, the body 10 may be formed of a light-transmissive resin material or a resin material having a phosphor that converts the wavelength of incident light.

A side portions of the body 10 may include a first side portion 11 and a second side portion 12 disposed on both sides in the third direction Z, and third and fourth side portions 13 and 14 disposed on both sides in the first direction X. The first side portion 11 and the second side portion 12 may be lower and upper surfaces of the body 10. The third and fourth side portions 13 and 14 are adjacent to the first side portion 11 and the second side portion 12, respectively, and may be one side and the other side of the body 10. The body 10 may include a front side portion 15 and a rear side portion 16 on both sides in the second direction Y, and the front side portion 15 and the rear side portion 16 may be a front surface (i.e., front side) of the body 10 and a rear side (i.e., back side).

The first and second side portions 11 and 12 are long sides having the length of the body 10, and the third and fourth side portions 13 and 14 are short sides having the width of the body 10, and the front side portion 15 and the rear side portion 16 may be long sides having the length of the body 10. The first side portion 11 of the body 10 may be a side facing the circuit board 401 shown in FIG. 4. The third and fourth side portions 13 and 14 may be sides perpendicular to the upper surface of the circuit board 401. The length of the body 10 in the first direction X is a distance between the third and fourth side portions 13 and 14, and may be twice or more than a distance (i.e., the thickness) between the first and second side portions 11 and 12. In the body 10, the front side portion 15 may be a surface in which the cavity 15A is opened, and may be a surface perpendicular to the upper surface of the circuit board 401. The rear side portion 16 opposite to the front side portion 15 is a surface perpendicular to the circuit board 401 and may include a recess 16B concave toward the front side portion 15.

The plurality of lead frames 20, 30, and 40 may be spaced apart from a bottom of the cavity 15A in the first direction X. Two or three of the plurality of lead frames 20, 30, and 40 may be disposed on the bottom of the cavity 15A, and may be electrically connected to the light emitting chips 71 and 72. When the plurality of lead frames 20, 30, and 40 are three, one may have a positive polarity and the other two may have a negative polarity. The plurality of lead frames 20, 30, and 40 may include three frames, for example, a first lead frame 20, a second lead frame 30 and a third lead frame 40.

The cavity 15A may include first and second inner surfaces 11A and 12A. The first inner side portion 11A is adjacent to the first side portion 11 and may be inclined or curved toward the bottom of the cavity 15A from the front side portion 15. The second inner side portion 12A is adjacent to the second side portion 12 and may be inclined or curved toward the bottom of the cavity 15A from the front side portion 15. The first and second inner surfaces 11A and 12A may face each other. The front side portion 15 of the cavity 15A of the body 10 may be open, and both sides in the first direction X may be open. Light emitted from the light emitting chips 71 and 72 may be emitted from the front emission surface 111 of the cavity 15A. The length of each of the first and second inner surfaces 11A and 12A of the cavity 15A may be the same as the length of the body 10 in the first direction X. The bottom length of the cavity 15A may be the same as the length of the body 10 in the first direction X. The body 10 may include a first bottom supporting portion 13A disposed on one side of the bottom of the cavity 15A and are disposed between the lead frames 20, 30, and 40 and the third side portion 13, and a second bottom supporting portion 14A disposed on the other side of the bottom of the cavity 15A and between the lead frames 20, 30, 40 and the fourth side portion 14.

The first bottom supporting portion 13A of the body 10 supports the second lead frame 30 at one side of the bottom of the cavity 15A adjacent to the third side portion 13, and the second bottom supporting portion 14A supports the third lead frame 40 on the other side of the bottom of the cavity 15A adjacent to the fourth side portion 14. The first bottom supporting portion 13A and/or the second bottom supporting portion 14A may be removed, and in this case, the surfaces of the second and third lead frames 30 and 40 may be exposed on the one side and the other side of the bottom of the cavity 15A. As shown in FIG. 2, the first and second bottom supporting portions 13A and 14A may be disposed lower than upper surfaces of the light emitting chips 71 and 72. The gap A2 between the upper surfaces of the first and second bottom supporting portions 13A and 14A and the upper surfaces of the light emitting chips 71 and 72 may be 30% or more of the thickness of the light emitting chips 71 and 72, for example, in a range of 30% to 90%. The cavity 15A includes side emission surfaces 112 and 113 open on upper portions of the third and fourth side portions 13 and 14, and the side emission surfaces 112 and 113 are open regions of the first and second bottom supporting portions 13A and 14A and may emit light emitted from the light emitting chips 71 and 72 in both directions. The side emission surfaces 112 and 113 may be defined as first and second emission surfaces 112 and 113. The first bottom supporting portion 13A extends from the upper surface of the second frame 31 of the second lead frame 30 to the third side portion 13, and the second bottom supporting portion 14A may extend from the upper surface of the second frame 31 of the second lead frame 30 to the fourth frame 41 of the frame 40 to the fourth side portion 14. The first and second bottom supporting portions 13A and 14A may be provided as a surface having inner side surfaces inclined or entire upper surfaces inclined.

The height A3 of the side emission surfaces 112 and 113 of the cavity 15A may be smaller than the height from the upper surface of the second and third frames 31 and 41 to the upper end of the cavity 15A or the upper end of the body 10, and may be larger than the distance from the upper surface of the light emitting chips 71 and 72 to the upper end of the cavity 15A or the upper end of the body 10. The distance A1 between the third side portion 13 and the first light emitting chip 71 and between the fourth side portion 14 and the second light emitting chip 72 may be smaller than the distance between the first and second light emitting chips 71 and 72 and may be larger than the length (length in the X direction) of the upper surfaces of the first and second bottom supporting portions 13A and 14A.

The depth of the cavity 15A is a distance from the front side portion 15 of the body 10 to the bottom of the cavity 15A, and is 1/3 or less of the length of the body 10 in the second direction Y, for example, in the range of 0.3 mm±0.05 mm. When the depth of the cavity 15A is less than the above range, it is difficult to control the light spread angle. When the depth exceeds the above range, the length of the second direction Y of the body 10 increases or the light spread angle narrows. Here, the depth of the cavity 15A on the upper surfaces of the first and second bottom supporting portions 13A and 14A may be minimal.

The plurality of lead frames 20, 30, and 40 may be disposed on the bottom of the cavity 15A and may be partially bent to extend to the first side portion 11 of the body 10. The plurality of lead frames 20, 30, and 40 may include a first lead frame 20 and second and third lead frames 30 and 40 spaced apart from the first lead frame 20. The first lead frame 20 may be disposed between the second and third lead frames 30 and 40. The lead frames 20, 30, and 40 include at least one of Cu, Al, Ni, Au, and Ag, and may be formed of a single layer or multiple layers. Au layer may be formed on surfaces of the lead frames 20, 30, and 40 for bonding. The lead frames 20, 30, and 40 may have a thickness of 0.08 mm or more, for example, in the range of 0.08 mm to 0.2 mm. When it is smaller than the above range, heat dissipation efficiency or heat conduction efficiency may be reduced, and when it is greater than the above range, the package thickness may be increased.

The first lead frame 20 may include a first frame 21 disposed at the center of the bottom of the cavity 15A and a first bonding portion 22 bent from the first frame 21 toward the first side portion 11. The second lead frame 30 may include a second frame 31 disposed on one side of the bottom of the cavity 15A and a second bonding portion 32 bent from the second frame 31 toward the first side portion 11. The third lead frame 40 may include a third frame 41 disposed on the other side of the bottom of the cavity 15A and a second bonding portion 42 bent from the third frame 41 toward the first side portion 11.

The plurality of light emitting chips 71 and 72 may include a first light emitting chip 71 bonded and electrically connected to the first frame 21 and the second frame 31, and a second light emitting chip 72 bonded and electrically connected to the first frame 21 and the third frame 41. The first and second light emitting chips 71 and 72 may be arranged in a flip chip method. As another example, the first and second light emitting chips 71 and 72 may be selectively connected to at least one of the first, second, and third frames 21, 31, and 41 using a wire. Here, an Au layer or an uppermost layer bonded to the pads of the light emitting chips 71 and 72 may be formed on surfaces (or upper surfaces) of the first, second, and third frames 21, 31, and 41. In order to reduce the region of the Au layer or the uppermost layer, a groove region 21A from which the Au layer or the uppermost layer is removed may be formed on a part of the surface (or upper surface) of the first frame 21, that is, in a center region. The groove region 21A is stepped lower than the surface (or upper surface) of the first frame 21, and a layer below the uppermost layer, for example, a Cu, Al, or Ag layer may be exposed. Accordingly, it is possible to reduce the distance between the lead frames by reducing the plating region of the Au layer. The length of the groove region 21A in the first direction X may be longer than the respective lengths of the light emitting chips 71 and 72, and the width in the third direction Z may be a width of the bottom of the cavity 15A.

The body 10 includes separation portions 18 and 19 disposed at the bottom of the cavity 15A, and the separation portions 18 and 19 may be disposed between the first frame 21 and the second frame 31 and between the first frame 21 and the third frame 41, respectively. The separation portions 18 and 19 may be arranged parallel to each other or in an oblique shape. The separation portions 18 and 19 and the first and second bottom supporting portions 13A and 14A may be made of the same material or different materials.

As shown in FIGS. 1 and 3, the first bonding portion 22 of the first lead frame 20 may be disposed at the center of the first side portion 11 of the body 10 and may be bent toward the rear side portion 16. The first lead frame 20 may include a plurality of connection portions 25, 26, and 27 and a plurality of coupling holes H1 and H2 disposed between the plurality of connection portions 25, 26, and 27. The plurality of connection portions 25, 26, and 27 and the plurality of coupling holes H1 and H2 may be part of the first bonding portion 22. The plurality of connection portions 25, 26, and 27 are bent from the first frame 21 toward the first side portion 11 and disposed in a direction from the second bonding portion 32 to the third bonding portion 42, respectively. The plurality of coupling holes H1 and H2 may be respectively disposed between the plurality of connection portions 25, 26, and 27. For example, the number of the connection portions 25, 26, and 27 may be greater than the number of the coupling holes H1 and H2. The connection portions 25, 26, and 27 include a first connection portion 25, a second connection portion 26, and a third connection portion 27 spaced apart in the first direction X, and the coupling holes H1 and H2 may include a first coupling hole H1 and a second coupling hole H2 spaced apart in the first direction X. The second connection portion 26 may be disposed between the first connection portion 25 and the third connection portion 27. The second connection portion 26 may be disposed between the first coupling hole H1 and the second coupling hole H2. The first coupling hole H1 may be disposed between the first connection portion 25 and the second connection portion 26, and the second coupling hole H2 may be disposed between the second connection portion 26 and the third connection portion 27.

The second bonding portion 32 of the second lead frame 30 is disposed on one side of the first side portion 11 of the body 10, and may be bent toward the rear side portion. The third bonding portion 42 is disposed on the other side of the first side portion 11 of the body 10, and may be bent toward the rear side portion. The second bonding portion 32 of the second lead frame 30 includes a first extension portion 33 to increase a heat dissipation area, and the first extension portion 33 extends from a part of the second bonding portion 32 toward the third side portion 13 of the body 10, and a portion 33A of the first extension portion 33 may be bent to face the third side portion 13. The portion 33A of the first extension portion 33 may face or be adjacent to the third side portion 13 of the second body 10B.

The third bonding portion 42 of the third lead frame 40 includes a second extension portion 43 to increase a heat dissipation area, and the second extension portion 43 extends from a part of the third bonding portion 42 toward the fourth side portion 14 of the body 10, and a portion 43A of the second extension portion 43 may be bent to face the fourth side portion 14. The portion 43A of the second extension portion 43 may face or be adjacent to the fourth side portion 14 of the second body 10B. A heat dissipation area may be increased by the first and second extension portions 33 and 43. As shown in FIG. 1, gaps 17A and 17B may be formed between the portion 33A of the first extension part 33 and the third side portion 13 and between the portion 43A of the second extension portion 43 and the fourth side portion 14. That is, the portion 33A of the first extension part 33 may be spaced apart from the third side portion 13 by a thickness greater than or equal to the thickness of the second lead frame 30, and a portion 43A of the second extension part 43 may be spaced apart from the fourth side portion 14 by a thickness equal to or greater than the thickness of the third lead frame 40. Accordingly, the portion 33A of the first extension portion 33 and the portion 43A of the second extension portion 43 may be disposed on the outermost sides of both sides of the body 10. AS shown in FIGS. 1 and 3, the first side portion 11 of the body 10 has concave regions 11B and 11C adjacent to the third and fourth side portions 13 and 14, and the second and third bonding portions 32 and 42 of the second and third lead frames 30 and 40 may be disposed in the concave regions 11B and 11C.

The light emitting chips 71 and 72 may have a horizontal chip structure or a flip chip structure. The light emitting chips 71 and 72 may selectively emit light within a wavelength range of ultraviolet to visible light. The light emitting chips 71 and 72 may be selected from, for example, red LED chips, blue LED chips, green LED chips, and yellow green LED chips. The light emitting chips 71 and 72 may emit, for example, a red peak wavelength. The light emitting chips 71 and 72 may include at least one of a group II-VI compound and a group III-V compound. The light emitting chips 71 and 72 may be formed of, for example, a compound selected from the group consisting of GaN, AlGaN, InGaN, AlInGaN, GaP, AlN, GaAs, AlGaAs, InP, and mixtures thereof. Since the plurality of light emitting chips 71 and 72 are bonded to different frames 21, 31 and 41, heat generated from the light emitting chips 71 and 72 may be effectively dissipated and a decrease in light output may be prevented.

A molding member 80 is disposed in the cavity 15A of the body 10, and the molding member 80 includes a light transmitting resin such as silicon or epoxy and may be formed in a single layer or multiple layers. When the light emitting chips 71 and 72 are red LED chips, impurities such as phosphors may not be included in the molding member 80. An upper surface and both side surfaces of the molding member 80 may be exposed from the body 10. The upper surface of the molding member 80 may be concave, convex or flat, and both side surfaces of the molding member 80 may be disposed on the third and fourth side portions 13 and 14. A length of the molding member 80 in the first direction X may be the same as that of the cavity 15A. The length of the molding member 80 in the first direction X may be the same as the length of the body 10. A phosphor for changing a wavelength of emitted light may be included on the surface of the molding member 80 or the light emitting chips 71 and 72, and the phosphor excites a part of the light emitted from the light emitting chips 71 and 72 and emits light of a different wavelength. The phosphor may be selectively formed from quantum dots, YAG, TAG, silicate, nitride, and oxy-nitride-based materials. The phosphor may include at least one of a red phosphor, a yellow phosphor, and a green phosphor, but is not limited thereto. As another example, a light-transmissive film having a phosphor or a transparent or red optical plate may be further disposed on the upper portion of the cavity 15A or on the package. A lens may be further formed on the upper portion of the body 10, and the lens may include a structure of a concave lens or/and a convex lens, and may control light distribution of light emitted from the light emitting device package 100. Semiconductor device such as a light receiving device and a protection device may be mounted on the body 10 or any one of the lead frames, and the protection device may be implemented as a thyristor, a Zener diode, or a transient voltage suppression (TVS), The Zener diode protects the light emitting chips 71 and 72 from ESD (electro static discharge). The plurality of light emitting chips 71 and 72 may be connected in parallel or individually driven by the first to third lead frames 20, 30, and 40.

FIGS. 4 and 5 are views illustrating a light emitting module having the light emitting device package of FIG. 1. Referring to FIGS. 4 and 5, the light emitting module includes a circuit board 401 and one or a plurality of light emitting device packages 100 disposed on the circuit board 401. The circuit board 401 includes a board on which a circuit pattern is printed on an insulating layer, and for example, a resin-based printed circuit board (PCB), a metal core PCB, a flexible PCB, ceramic PCB, FR-4 substrate. The circuit board 401 includes a metal core PCB, and the metal core PCB further includes a metal layer having better heat dissipation efficiency than other resin-based substrates. For example, a metal core PCB includes a multilayer structure having a metal layer, an insulating layer on the metal layer, and a wiring layer on the insulating layer, and the metal layer is formed with a metal having good thermal conductivity to a thickness of 0.3 mm or more to increase heat dissipation efficiency.

The first to third lead frames 20, 30, and 40 of the light emitting device package 100 may be bonded to the pad portions 122, 123, and 124 of the circuit board 401 using an adhesive member 250. The bonding member 250 may include solder or conductive tape. The light emission surface of the light emitting device package 100 may be in a direction perpendicular to the upper surface of the circuit board 401. The light emission surface of the light emitting device package 100 may be a front surface and both side surfaces. A reflective member 410 is disposed on the circuit board 401, and the reflective member 410 may prevent overflow of solder and protect patterns of the pad portions 122, 123, and 124, and may reflect the light emitted from the light emitting device package 100. Since the front and both sides of the cavity 15A on the front side portion 15 of the light emitting device package 100 are open, the beam angle of the emitted light may be 160 degrees or more in the first direction, for example, in the range of 160 degrees to 220 degrees. Accordingly, light emitted from the light emitting device package 100 is emitted through the front direction and both side directions, and some light may progress toward the rear direction through both side surfaces.

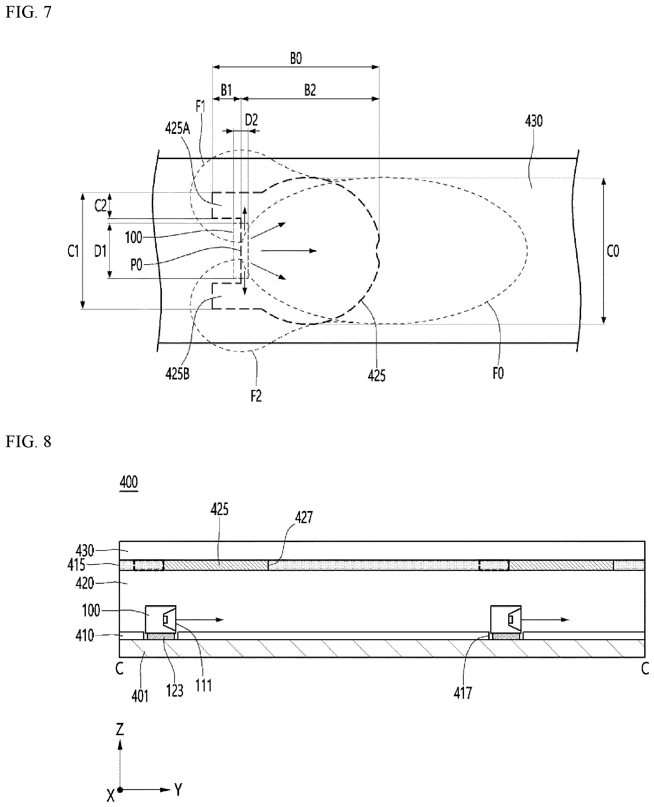

FIG. 6 is a plan view illustrating a lighting device having a light emitting device package of FIG. 1 or a light emitting module of FIG. 5, FIG. 7 is a view showing an example of a light blocking portion of FIG. 6, and FIG. 8 is a C-C cross-sectional view of the lighting device of FIG. 6.

Referring to FIGS. 6 to 8, the lighting device 400 according to an embodiment of the invention includes a circuit board 401, a plurality of light emitting device packages 100 disposed on the circuit board 401, and a resin layer 420 covering the light emitting device packages 100 disposed on the circuit board 401, and a diffusion layer 430 on the resin layer 420. The lighting device 400 may include a reflective member 410 disposed on the circuit board 401. The lighting device 400 according to an embodiment of the invention may emit light emitted from the light emitting device package 100 as a surface light source. The plurality of light emitting device packages 100 may be disposed on the circuit board 401 at regular intervals G1 or at different intervals.

The circuit board 401 may be electrically connected to the light emitting device package 100. The circuit board 401 includes a wiring layer (not shown) thereon, and the wiring layer may be electrically connected to the light emitting device package 100. The plurality of light emitting device packages 100 may be connected in series, parallel, or series-parallel by the wiring layer. The circuit board 401 may function as a base member or a support member disposed under the light emitting device package 100 and the resin layer 420. The circuit board 401 may include a light transmitting material through which light is transmitted through upper and lower surfaces. The light transmitting material may include at least one of polyethylene terephthalate (PET), polystyrene (PS), and polyimide (PI).

The light emitting device package 100 is disposed on the circuit board 401 and emits light toward the front side portion and the third and fourth side portions 13 and 14 (see FIG. 1). That is, as shown in FIG. 7, the light emitted from the light emitting device package 100 may be emitted in a distribution of the main beam F0 and side beams F1 and F2 on both sides. The light emitting device package 100 emits the main beam F0 having the highest intensity in the second direction Y. The light emitting device package 100 may be electrically connected to the pad portion (e.g., 123) of the circuit board 401 by a conductive bonding member on the circuit board 401. The bonding member may be a solder material or a metal material.

The light emitting device package 100 may be disposed as a first light emitting device package from one end of the circuit board 401 and a second light emitting device package in an emission direction of the first light emitting device package. The first light emitting device package and the second light emitting device package radiate light toward the other end of the circuit board 401 or in a second direction. That is, the first light emitting device package radiates light in the direction of the second light emitting device package, and the second light emitting device package radiates light toward the other end of the circuit board 401 or in a direction opposite to where the first light emitting device package is disposed. The light emitting device package 100 refers to the package disclosed above, and a detailed description thereof will be omitted.

The reflective member 410 may be disposed between the circuit board 401 and the resin layer 420. The reflective member 410 may be provided in the form of a film having a metal material or a non-metal material. The reflective member 410 may be adhered to an upper surface of the circuit board 401. The reflective member 410 may have an area smaller than the area of the upper surface of the circuit board 401. The reflective member 410 may be spaced apart from the edge of the circuit board 401, and a resin layer 420 may be attached to the circuit board 401 in the spaced region. In this case, peeling of the edge portion of the reflective member 410 may be prevented. The reflective member 410 may include an opening 417 in which a lower portion of the light emitting device package 100 is disposed. A portion in which the upper surface of the circuit board 401 is exposed and the lower portion of the light emitting device package 100 is bonded may be disposed in the opening 417 of the reflective member 410. The size of the opening 417 may be the same as or larger than the size of the light emitting device package 100, but is not limited thereto. The reflective member 410 may contact the upper surface of the circuit board 401 or may be adhered between the resin layer 420 and the circuit board 401, but is not limited thereto. Here, the reflective member 410 may be removed when a highly reflective material is coated on the upper surface of the circuit board 401. The reflective member 410 may be formed to have a thickness smaller than that of the light emitting device package 100. The thickness of the reflective member 410 may include a range of 0.2 mm ± 0.02 mm. A lower portion of the light emitting device package 100 may pass through the opening 417 of the reflective member 410 and an upper portion of the light emitting device package 100 may protrude. The emission surface 111 of the light emitting device package 100 may be provided in a direction perpendicular to the upper surface of the reflective member 410.

The reflective member 410 may include a plurality of open regions 411 and 413. The plurality of open regions 411 and 413 include a plurality of first and second open regions 411 and 413, and the plurality of first open regions 411 may be arranged in the second direction Y. The second open region 413 of may be arranged in the second direction Y. The first and second open regions 411 and 413 may be spaced apart in the first direction X. The first open region 411 and the second open region 413 may be adjacent to both side surfaces of the circuit board 401. Each of the first open regions 411 may overlap each of the second open regions 413 in the first direction X. The first and second open regions 411 and 413 may not overlap the light emitting device package 100 in the first direction X. Each of the first and second open regions 411 and 413 may have an elliptical shape, a circular shape, or a polygonal shape. Since each of the first and second open regions 411 and 413 of the reflective member 410 is long in the second direction, deterioration in adhesive strength of the region adjacent to the long side edge of the circuit board 401 may be prevented. The resin layer 420 may be disposed on the first and second open regions 411 and 413 and the reflective member 410. The resin layer 420 may be adhered to the upper surface of the circuit board 401 through the first and second open regions 411 and 413 to fix the outer portion of the reflective member 410.

The resin layer 420 may be disposed on the circuit board 401. The resin layer 420 may face the circuit board 401. The resin layer 420 may be disposed on the entire upper surface or a partial area of the circuit board 401. A lower surface area of the resin layer 420 may be equal to or smaller than an upper surface area of the circuit board 401. The resin layer 420 may be formed of a transparent material. The resin layer 420 may include a resin material such as silicone or epoxy. Since the resin layer 420 is provided as a layer for guiding light with resin, it may be provided with a thinner thickness than glass and can be provided as a flexible plate. The resin layer 420 may emit a point light source emitted from the light emitting device package 100 in the form of linear light or planar light. Since the resin layer 420 is disposed on the light emitting device package 100, the light emitting device package 100 may be protected and loss of light emitted from the light emitting device package 100 may be reduced. The light emitting device package 100 may be buried under the resin layer 420.

The resin layer 420 may contact a surface of the light emitting device packages 100 and a surface of the emission surface (see 111, 112, and 113 in FIG. 2) of the light emitting device packages 100. A portion of the resin layer 420 may be disposed in the opening 417 of the reflective member 410. A portion of the resin layer 420 may contact the upper surface of the circuit board 401 through the opening 417 of the reflective member 410. Accordingly, as a part of the resin layer 420 comes into contact with the circuit board 401, the reflective member 410 may be fixed between the resin layer 420 and the circuit board 401. The resin layer 420 may have a thickness of 1.8 mm or more, for example, in the range of 1.8 to 2.5 mm. When the thickness of the resin layer 420 is thicker than the above range, the luminous intensity may decrease, and it may be difficult to provide a flexible module due to the increase in module thickness. When the thickness of the resin layer 420 is smaller than the above range, it is difficult to provide a surface light source with uniform light intensity.

The resin layer 420 may be provided in a size to cover the plurality of light emitting device packages 100 or may be connected to each other. The resin layer 420 may be separated into a size that covers each light emitting device package 100, and may be divided into each light emitting device package 100/light emitting cell having each resin layer 420.

A light transmitting layer 415 may be disposed between the resin layer 420 and the diffusion layer 430. The light transmitting layer 415 may attach the diffusion layer 430 to the resin layer 420. The light transmitting layer 415 may include an adhesive material such as silicon or epoxy, or a diffusion material. The diffusion material may include at least one of polyester (PET), poly methyl methacrylate (PMMA), or poly carbonate (PC). The light transmitting layer 415 may include an adhesive region adhering to the upper surface of the resin layer 420 and a non-adhesive region not adhering to or spaced apart from the upper surface of the resin layer 420. The light transmitting layer 415 is disposed on 60% or more, for example, 80% or more and 95% or less of the upper surface area of the resin layer 420, so that the diffusion layer 430 may adhere to the resin layer 420 or the lower diffusion layer (not shown). Here, when the plurality of diffusion layers 430 are disposed, it may be divided into a lower diffusion layer adjacent to the resin layer 430 and an upper diffusion layer thereon. A light blocking portion 425 may be disposed between the resin layer 420 and the diffusion layer 430. The light blocking portion 425 may contact the light transmitting layer 415. The light blocking portion 425 may overlap the light emitting device package 100 in a vertical direction or a third direction Z. The light blocking portion 425 may face the upper surface of the resin layer 420. Each of the plurality of light blocking portions 425 may overlap each of the plurality of light emitting device packages 100 in the vertical direction. When a plurality of diffusion layers 430 are disposed, the light blocking portion 425 may be disposed between the plurality of diffusion layers.

The light blocking portion 425 may be disposed within the light transmitting layer 415. The light blocking portion 425 may pass through the light transmitting layer 415 and may contact at least one of the resin layer 420 and the diffusion layer 430. The light blocking portion 425 may include a gap portion 427 spaced apart from an inner surface of the light transmitting layer 415 or/and an upper surface of the resin layer 420. The gap portion 427 may provide a refractive index different from that of the light blocking portion 425, thereby improving light diffusion efficiency. A distance Q2 between the light blocking portion 425 and another light emitting device package 100 may be smaller than a distance Q1 between the light emitting device packages 100. The light blocking portions 425 may be spaced apart from an outer surface of the resin layer 420. The plurality of light blocking portions 425 are arranged along the light emitting device package 100 and may have the same shape as each other. Each of the light blocking portions 425 has an area larger than the top surface area of each light emitting device package 100 and may suppress a hot spot caused by light emitted through the light emitting device package 100.

The light blocking portion 425 may be disposed higher than the upper surface of the resin layer 420. The light blocking portion 425 may have an area on the light emitting device package 100 that is one or more times larger than the area of the upper surface of the light emitting device package 100 or in a range of 1 to 10 times. The light blocking portion 425 may be a region printed with a white material. The light blocking portion 425 may be printed using a reflective ink containing any one of, for example, TiO₂, Al₂O₃, CaCO₃, BaSO₄, and Silicon. The light blocking portion 425 reflects light emitted through the emission surface of the light emitting device package 100 to reduce occurrence of hot spots on the light emitting device package 100. The light blocking portion 425 may print a light blocking pattern using light blocking ink. The light blocking portion 425 may be formed by printing on the lower surface of the diffusion layer 430. The light blocking portion 425 is a material that does not block 100% of incident light, and may have transmittance lower than reflectance, and may perform functions of blocking and diffusing light. The light blocking portion 425 may be formed in a single layer or multiple layers, and may have the same pattern shape or different pattern shapes. The light blocking portion 425 may have the same thickness. The light blocking portion 425 may have a different thickness according to regions. The thickness of the light blocking portion 425 may be the thickest in the center region and thinner in the edge region than the center region. The light blocking portion 425 may be thick in proportion to the incident light intensity.

Since the size of the light blocking portion 425 is larger than the area of the upper surface of the light emitting device package 100, the problem of the light emitting device package 100 being visible from the outside is reduced and the hot spot on the region of the light emitting device package 100 may be reduced, so that a uniform light distribution may be provided over the entire region.

Referring to FIG. 7, describing at the width of the light blocking portion 425, the width C1 of the rear region of the light emitting device package 100 in the first direction X is small and gradually increases toward the center portion of the light blocking portion 425, and the width (e.g., CO) in the first direction X at the center portion may be maximized. A width in the second direction Y may gradually decrease as a distance from the light emitting device package 100 is increased from the center portion of the light blocking portion 425. The maximum width C3 in the second direction Y at the center portion of the light blocking portion 425 is the largest, and the width in the first direction X may gradually decrease as the distance from the center of the light blocking portion 425 in the first direction X increases. The light blocking portion 425 may include first and second sub-light blocking portions 425A and 425B spaced apart in the first direction X with respect to the light emitting device package 100. The first sub-light blocking portion 425A blocks the first sub-beam F1 on the side of the light emitting device package 100, and the second sub-light blocking portion 425B blocks the second sub-beam F2. To this end, the first sub-light blocking portion 425A extends outwardly and rearward on the third side portion (see 13 in FIG. 1) of the light emitting device package 100, and covers the upper portion and its surrounding region of the third side portion (see 13 in FIG. 1). The second sub-light blocking portion 425B extends outwardly and rearward on the fourth side portion (see 14 in FIG. 1) of the light emitting device package 100, and covers the upper portion and its surrounding region of the fourth side portion (see 14 in FIG. 1). The first and second sub-light blocking portions 425A and 425B may have a polygonal shape, a circular shape, or an elliptical shape in a top view.

The maximum length of the light blocking portion 425 in the second direction Y is B0, the length of the first and second sub-light blocking portions 425A and 425B is B1 based on the center of the light source P0, and the length of the light blocking region of the main beam is B2, a ratio of B1:B2 may range from 1:2 to 1:10. Here, when the width of the light emitting device package 100 in the second direction Y is D2, a ratio of D2:B1 may be in the range of 1:1.5 to 1:3. The first and second sub-light blocking portions 425A and 425B cover the rear side of the light emitting device package 100 to effectively block light from the first and second side emission surfaces (see 112 and 113 in FIG. 2 ) and the upper portion of its surrounding region. When the length of the rear region of the light blocking portion 425 in the first direction X is C1 and the width of each sub-light blocking portion 425A or 425B is C2, a ratio of C1:C2 may be in a rage of 1:0.2 to 1:0.4. Here, when the length of the first direction X of the light emitting device package 100 is D1, a ratio of D1:C2 may be in the range of 1:0.5 to 1:1.2. The first and second sub-light blocking portions 425A and 425B cover the rear side of the light emitting device package 100 to effectively block light from the first and second side emission surfaces (see 112 and 113 in FIG. 2) and the upper portion of its surrounding region. Here, the width C0 of the light blocking portion 420 in the first direction X may be 10 mm or more, for example, in the range of 10 mm to 20 mm, and the maximum length B0 in the second direction Y may be less than or equal to the width C0, and may be greater than or equal to 9 mm, such as in the range of 9 mm to 18 mm. A width C2 of the sub-light blocking portions 425A and 425B may be 5 mm or less, for example, in the range of 2 mm to 5 mm. The length B1 of the first and second sub-light blocking portions 425A and 425B may be 5 mm or less, for example, in the range of 2 mm to 5 mm, and may be smaller than the width C2.

The thickness of the light blocking portion 425 may be 0.1 times or less, for example, 0.05 to 0.1 times the thickness of the resin layer 420. The light blocking portion 425 may have a thickness of 100 µm or more, for example, in a range of 100 µm to 200 µm. When the thickness of the light blocking portion 425 is less than the above range, there is a limit to reducing hot spots, and when it is greater than the above range, light uniformity may be degraded. A distance between the upper surface of the light emitting device package 100 and the lower surface of the light blocking portion 425 may be greater than or equal to 0.4 mm, for example, in the range of 0.4 mm to 0.6 mm. The distance between the upper surface of the light emitting device package 100 and the upper surface of the reflective member 410 may be greater than or equal to 0.8 mm, for example, in the range of 0.8 mm to 1.4 mm. A region of the light blocking portion 425 may not overlap an area of the light transmitting layer 415 in the vertical direction. The light blocking portion 425 may be provided in a size or area sufficient to prevent hot spots caused by light emitted from the light emitting device packages 100 in the emission direction and the lateral direction of the light emitting device package 100. In addition, the sub-light blocking portions 425A and 425B of the light blocking portion 425 may improve the surface light distribution of the light emitted through the diffusion layer 430 by blocking light emitted in both directions of the light emitting device package 100, that is, in the first direction X and in the rear direction based on the center of the light source P0.

The diffusion layer 430 may be disposed on the resin layer 420. A lower surface of the diffusion layer 430 may be disposed on the light transmitting layer 415 and the light blocking portion 425. The light blocking portion 425 may be printed on the lower surface of the diffusion layer 430 and may be fixed on the resin layer 420 through the light transmitting layer 415. The diffusion layer 430 may include at least one of a polyester (PET) film, a poly methyl methacrylate (PMMA) material, or a poly carbonate (PC) material. The diffusion layer 430 may be provided with a resin material film such as silicon or epoxy. The diffusion layer 430 may include a single layer or multiple layers. The diffusion layer 430 may have a thickness of 25 µm or more, for example, 25 to 250 µm or 100 to 250 µm. The diffusion layer 430 has the thickness range and may provide incident light as a uniform surface light source. The diffusion layer 430 may include at least one or two or more of diffusion agents such as a bead, a phosphor, and ink particles. The phosphor may include, for example, at least one of a red phosphor, an amber phosphor, a yellow phosphor, a green phosphor, or a white phosphor. The ink particles may include at least one of metal ink, UV ink, and curing ink. A size of the ink particle may be smaller than a size of the phosphor. The surface color of the ink particle may be any one of green, red, yellow, and blue. The ink types include PVC (Poly vinyl chloride) ink, PC (Polycarbonate) ink, ABS (acrylonitrile butadiene styrene copolymer) ink, UV resin ink, epoxy ink, silicone ink, PP (polypropylene) ink, water-based ink, plastic ink, PMMA (poly methyl methacrylate) ink and PS (Polystyrene) ink. The ink particles may include at least one of metal ink, UV ink, and curing ink.

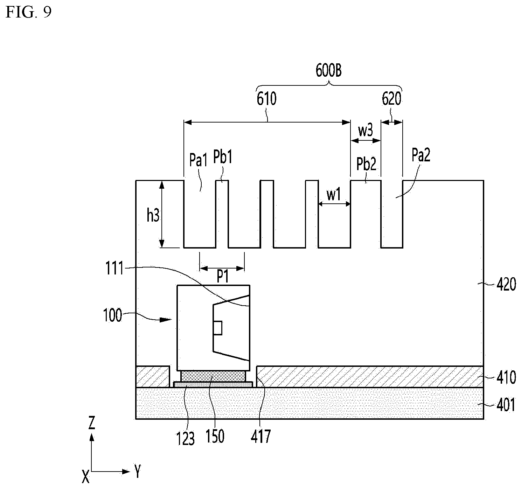

In an exemplary embodiment of the invention, light diffused by the resin layer 420 may be transmitted through the light transmitting layer 415 and emitted as a surface light source through the diffusion layer 430. In this case, the light blocking portion 425 may prevent hot spots caused by incident light. In another example of the invention, a layer of a reflective material or an upper substrate may be disposed on the upper portion of the resin layer 420. The layer of the reflective material or the upper substrate may face the upper surface of the resin layer 420, the light emitting device packages 100 are arranged in at least one row or column, and each emission surface of the light emitting device packages 100 are arranged at the same interval from one side of the resin layer 420, and light may be emitted through one side of the resin layer 420. As another example, the light blocking portion 425 may be formed as an optical pattern portion having a concave-convex pattern on the upper surface of the resin layer 420 as shown in FIG. 9. The top view shape of the optical pattern portion 600 serving the light blocking function of FIG. 9 may be the same as that of FIG. 7, and the structure of the pattern will be described.

Referring to FIG. 9, the optical pattern portion 600 includes a plurality of concave portions Pa1 and Pa2 concave on the upper surface of the resin layer 420, and the top view shapes of the concave portions Pa1 and Pa2 have a polygonal shape (e.g., triangular, square or pentagonal, etc.) or circular or elliptical in shape. The upper surface area of each of the concave portions Pa1 and Pa2 may be provided in the same size or different sizes. The upper surface area of each of the concave portions Pa1 and Pa2 may be arranged to have the same size in each region, and may be provided in different sizes in different areas. The concave portions Pa1 and Pa2 may be spaced apart at predetermined intervals, and the interval may be smaller than lengths of the concave portions Pa1 and Pa2 in the first and second directions X and Y. the intervals between the concave portions Pa1 and Pa2 may be equal to each other. The intervals between the concave portions Pa1 and Pa2 may include a region having a regular interval and a region having an interval smaller or larger than the interval. The concave portions Pa1 and Pa2 may have the same or different intervals in the first direction X and in the second direction Y. In the optical pattern portion 600, the concave portions Pa1 and Pa2 and the convex portions Pb1 and Pb2 may be alternately arranged. The widths of the concave portions Pa1 and Pa2 in the first direction X and/or the second direction Y may be smaller than the depth h1. The concave portions Pa1 and Pa2 may have a columnar shape having a deep depth h1. An upper width and a lower width of the concave portions Pa1 and Pa2 may have the same width w1 as each other. Bottoms of the concave portions Pa1 and Pa2 may include a flat surface. Upper surfaces of the convex portions Pb1 and Pb2 between the concave portions Pa1 and Pa2 may have a constant width or may have different widths w3 according to regions. The convex portions Pb1 and Pb2 are connected to each other, and the concave portions Pa1 and Pa2 may be provided in a shape that is recessed toward the lower surface of the inner regions of the convex portions Pa1 and Pa2. The concave portions Pa1 and Pa2 may reflect, refract, or diffuse incident light. The convex portions Pb1 and Pb2 may reflect or refract the incident light, guide it upward, and diffuse it.

The optical pattern portion 600 may be divided into different pattern portions 610 and 620 according to the pattern size (e.g., width). In the optical pattern portion 600, the plurality of pattern portions 610 and 620 arranged in the first direction X may have different widths w1. The plurality of pattern portions 610 and 620 may extend in the second direction Y. For example, the plurality of pattern portions 610 and 620 may be disposed at the same depth h1, and the pitch P1 between adjacent concave portions Pa1 and Pa2 in the first and second directions X and Y may be the same or wider as it goes away from the emission surface 111 of the light emitting device package 100. The width of the convex portions Pb1 between the plurality of pattern portions 610 and 620 may be smaller than the width w1 of the adjacent concave portions Pa1 and Pa2, and the width w3 of the convex portion Pb1 in the far region may be equal to or smaller than the width w1. For example, the width w1 of the concave portions Pa1 and Pa2 may be greater than or equal to 0.4 mm, for example, in the range of 0.4 mm to 0.6 mm, and the width w3 may be less than 0.3 mm, for example, in the range of 0.29 mm to 0.38 mm. Accordingly, the area of the concave portion of the first pattern portion 610 is the largest in an region adjacent to the light emitting device package 100, and the area of the concave portion may decrease as the region becomes farther away from the light emitting device package 100, so pattern that may diffuse light in proportion to light intensity may be placed.

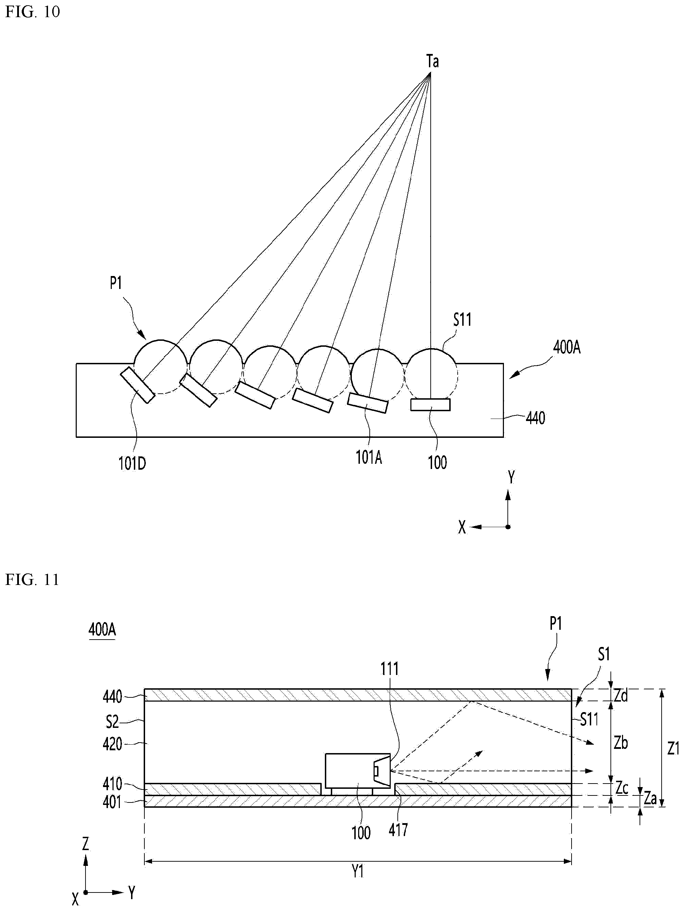

FIGS. 10 to 12 are other examples of a lighting device having the light emitting device package of FIG. 1.

Referring to FIGS. 10 and 11, a lighting device 400A may include a circuit board 401, a resin layer 420, a plurality of reflective layers 410 and 440, and one or a plurality of light emitting device packages 100 described above. The lighting device 400A includes a plurality of light emitting device packages 100, and emits light emitted from the plurality of light emitting device packages 100 as surface light having a line width or a resin thickness. Light emitted from the light emitting device package 100 may be emitted as surface light having a line width or a thin height. The lighting device 400A may be a flexible module or a rigid module. The lighting device 400A may be flat or curved in at least one of the first and second directions Y and X. The lighting device 400A may include both side surfaces corresponding to each other in the first direction X and both side surfaces corresponding to each other in the second direction Y. The line width through which light is emitted from the lighting device 400A is the height in the vertical direction Z, and may be 3 mm or less, for example, in the range of 2.4 mm to 3 mm. Illumination by the lighting device 400A may be provided in a straight, curved, or wavy module, so that the degree of freedom in lighting design may be improved, and it may be effectively installed in a bracket or housing lamp position.

As shown in FIG. 11, the emission surface of the lighting device 400A may be provided in a hemispherical shape. The centers of each light emitting device package 100, 101A, 101D and the convex portion P11 may be arranged toward the target point Ta so that each light emitting device package 100, 101A, and 101D of the lighting device 400A may be concentrated to the target point Ta. That is, each of the light emitting device package 100, 101A and 101D may have a larger inclined angle as the light emitting device packages 101A and 101D are further away from the light emitting device package 100 perpendicular to the target point Ta. A straight line passing through the center of the convex portion P11 and the convex surface S11 corresponding to each of the light emitting device packages 100, 101A and 101D and the center of each light emitting device package 100, 101A and 101D may intersect at the target point Ta. The distance between the target point Ta and each convex portion P11 may vary depending on the type of lamp.

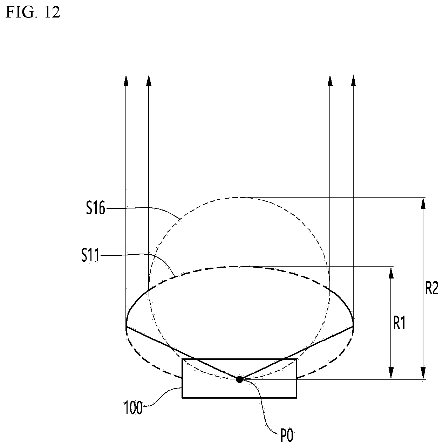

Referring to FIG. 12, the plurality of reflective layers 410 and 440 may include a first reflective layer 440 disposed on an upper surface of the resin layer 420 and a second reflective layer 410 disposed on a lower surface of the resin layer 420. The resin layer 420 may include a first surface S1 and a second surface S2 disposed on both sides in the second direction Y. The first and second surfaces S1 and S2 may be disposed to correspond to each other in the second direction Y, or may be disposed to correspond to each other based on a virtual line connecting the plurality of light emitting device packages 100. The emission surface 111 of each of the plurality of light emitting device packages 100 may correspond to the first surface S1. Light emitted from the light emitting device package 100 is emitted through the first surface S1, and some light may be emitted through the other surface. That is, most of the light emitted from the light emitting device package 100 may be emitted through the first surface S1. The thickness of the first surface S1 of the resin layer 420 is the thickness of the resin layer 420 and may be less than 3 mm.

The first surface S1 of the resin layer 420 may be an exit surface from which light emitted from the light emitting device package 100 is emitted. The first surface S1 may be a front surface or an exit surface, and the second surface S2 may be a rear surface or a non-exit surface. The first surface S1 may include a plurality of convex portions P11 arranged in a vertical plane along the first direction X. The first surface S1 may be a regular concave-convex shape or a side surface on which concavo-convex structures are arranged. The first surface S1 may be a region having a larger surface area than that of the opposite second surface S2. The first surface S1 may include a plurality of convex surfaces S11 corresponding to each light emitting device package 100 and a plurality of concave portions respectively disposed between the plurality of convex surfaces S11. Side surfaces of the circuit board 401, the resin layer 420, and the first reflective layer 440, that is, a vertical surface of the convex portion P11 may be disposed on the same plane.

The resin layer 420 may be disposed between the first and second reflective layers 440 and 410. The first and second reflective layers 440 and 410 may have the same area and face the upper and lower surfaces of the resin layer 420. The first and second reflective layers 440 and 410 may be made of the same material or different materials. Accordingly, the resin layer 420 diffuses the light emitted from the light emitting device package 100 and the light reflected by the first and second reflective layers 440 and 410 to guide and emit the light toward the first surface S1.

A thickness Zc of the second reflective layer 410 may be smaller than a thickness Za of the circuit board 401. The second reflective layer 410 may have a thickness Zc greater than or equal to 0.5 times and less than 1 time the thickness Za of the circuit board 401, thereby reducing transmission loss of incident light. The thickness Zc of the second reflective layer 410 may be in the range of 0.2 mm to 0.4 mm, when it is smaller than the above range, light transmission loss may occur, and when it is thicker than the above range, the thickness Z1 of the lighting device 400A may increase. The first reflective layer 440 is disposed on the entire upper surface of the resin layer 420 to reduce loss of light. The resin layer 420 may be formed to have a thickness Zb greater than the thickness of the light emitting device package 100.

The thickness Zb of the resin layer 420 is a distance between the first and second reflective layers 440 and 410 and may be smaller than the distance between the first surface S1 and the second surface S2. By arranging the distance between the first and second reflective layers 440 and 410 to be smaller than the length or minimum width of the lighting device 400A in the first direction, a line-shaped surface light source may be provided through the first direction, and improving light intensity and preventing hot spots. In addition, the lighting device may be provided with a ductile property that has a constant thickness and may be convex or concave in the third direction Z. The thickness Zb of the resin layer 420 may be less than twice the thickness of the light emitting device package 100, and may be, for example, more than one time to less than twice the thickness of the light emitting device package 100. The thickness Zb of the resin layer 420 may be 2 mm or less, for example, 1.5 mm to 1.9 mm or 1.6 mm to 1.8 mm. Since the difference in thickness Z1 between the resin layer 420 and the lighting device 400A is less than 1.2 mm, a decrease in light efficiency in the lighting device 400A may be prevented and ductility properties may be enhanced.

The convex portion P11 or the convex surface S11 disposed on the first surface S1 of the resin layer 420 may have a first curvature. Here, the radius of curvature of the convex portion P11 may be 5 mm or more, for example, in a range of 5 mm to 50 mm or 8 mm to 30 mm. When the radius of curvature of each convex portion P11 is smaller than the above range, improvement in luminous intensity is insignificant, and when it is larger than the above range, a dark portion may be generated. A region of the resin layer 420 where the convex portion P11 is formed may serve as a lens portion. The lens portion of the resin layer 420 is provided in a lens shape having a convex surface, and may include a hemispherical shape, a semicircular shape, a semielliptical shape, or an aspheric shape when viewed from a top view. The lens may include a collimator lens. The lens portion may be further spaced from the light emitting device package 100 at vertices corresponding to the center of the light emitting device package 100. Accordingly, each of the convex surfaces S11 of the resin layer 420 may emit light emitted through each of the light emitting device packages 100. Here, the thickness Zd of the first reflective layer 440 may be in the range of 0.2 mm to 0.4 mm, and when it is smaller than the above range, light transmission loss may occur, and when it is thicker than the above range, the thickness Z1 of the lighting device 400A may increase. As shown in FIG. 10, since the lighting device 400A emits light in a beam angle distribution through each convex portion P11, more light may be condensed in a target region or in a direction in which light travels.

As shown in FIG. 12, since light is emitted through the front surface and both side surfaces of the light emitting device package 100 as shown in FIG. 1, the shape of the convex surface S11 may be provided in an elliptical shape. The elliptical convex surface S11 may provide a wider light distribution than the circular convex surface S16 of the comparative example. Accordingly, a wider interval between the light emitting device packages 100 may be provided, and occurrence of a dark part in a region between the light emitting device packages 100 may be minimized. At this time, the distance from the light source center P0 of the light emitting device package 100 to the convex surface S11 is 3 times or less than the width of the light emitting device package 100, and the distance to the convex surface S16 of the comparative example may be 3.3 times or more. Accordingly, since the area emitted from the light emitting device package 100 is wide and light is provided in the first direction, the length of the lighting device may be reduced by reducing the distance to the convex surface S11, and the emitted light intensity may be improved.

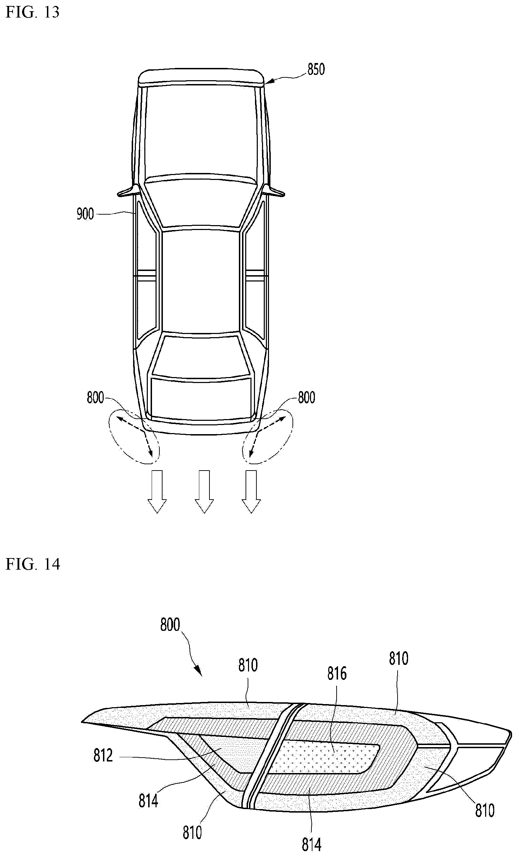

FIG. 13 is a plan view of a vehicle to which a vehicle lamp to which a lighting module according to an embodiment is applied, and FIG. 14 is a view showing a vehicle lamp having a lighting module or a lighting device disclosed in the embodiment.

Referring to FIGS. 13 and 14, a taillight 800 in a vehicle 900 may include a first lamp unit 812, a second lamp unit 814, a third lamp unit 816, and a housing 810. Here, the first lamp unit 812 may be a light source for a direction indicator light, the second lamp unit 814 may be a light source for a sidelight lamp, and the third lamp unit 816 may be a light source for a brake light, but is not limited thereto. At least one or all of the first to third lamp units 812, 814, and 816 may include the lighting module disclosed in the embodiment. The housing 810 accommodates the first to third lamp units 812, 814, and 816 and may be made of a light transmitting material. At this time, the housing 810 may have a curve according to the design of the vehicle body, and the first to third lamp units 812, 814, and 816 may implement a surface light source that may have a curved surface according to the shape of the housing 810. Such a vehicle lamp may be applied to a vehicle's turn signal lamp when the lamp unit is applied to a vehicle's tail lamp, brake lamp, or turn signal lamp.

The lighting module or the lighting device may be applied to various lamps requiring lighting, such as vehicle lamps, household lighting devices, and industrial lighting devices. For example, when applied to vehicle lamps, it may be applied to head lamps, side mirror lights, side maker lights, fog lights, tail lights, brake lights, daytime running lights, vehicle interior lights, door scars, rear combination lamps, backup lamps, etc. The lighting device of the invention may be applied to indoor and outdoor advertising devices, display devices, and various electric vehicle fields, and can be applied to all lighting-related fields or advertising-related fields that are currently developed, commercialized, or implemented according to future technological development.

## Claims

1. A lighting device comprising:
a circuit board;
a plurality of light emitting device packages disposed on the circuit board;
a resin layer covering the plurality of light emitting device packages; and
a layer that diffuses or reflects light on the resin layer,
wherein each of the light emitting device packages includes:
a body having a first side portion facing the circuit board, a second side portion opposite to the first side portion, third and fourth side portions on both sides of the first and second side portions, and a cavity in which a part of a front side portion is opened;
a plurality of lead frames each having a plurality of frames disposed on a bottom of the cavity and a bonding portion bent from each of the plurality of frames toward the first side portion; and
a plurality of light emitting chips electrically connected to the plurality of frames on the bottom of the cavity;
wherein the third side portion and the fourth side portion of the body are disposed on both sides of the body in a first direction,
wherein the front and rear side portions of the body are orthogonal to the first direction and are disposed on both sides of the body in a second direction, and
wherein the cavity has a length equal to a length of the body in the first direction.

2. The lighting device of claim 1, wherein the cavity includes a first reflective supporting portion disposed on any one frame adjacent to the third side portion and a second reflective supporting portion disposed on any other frame adjacent to the fourth side portion, and
wherein the first and second reflective supporting portions are disposed concave from the front side portion on both bottoms of the cavity in the first direction.

3. The lighting device of claim 1, comprising a molding member in the cavity,
wherein a length of the molding member is equal to a length of the cavity in the first direction.

4. The lighting device of claim 3, wherein the molding member is exposed to the front side portion and the third and fourth side portions of the body, respectively.

5. The lighting device of any one of claims 1 to 4, further comprising: a diffusion layer diffusing light on the resin layer; and a light transmitting layer and a light blocking portion between the resin layer and the diffusion layer,
wherein the light blocking portion vertically overlaps the light emitting device package.

6. The lighting device of claim 5, wherein the light blocking portion covers a front of the light emitting device package, and
wherein the light blocking portion includes first and second sub-light blocking portions respectively covering third and fourth side portions of the body of the light emitting device package.

7. The lighting device of claim 6, wherein the first and second sub-light blocking portions are spaced apart from each other in the first direction and extend further to both sides in the first direction and rearward in the second direction than the third and fourth side portions of the light emitting device package.

8. The lighting device of any one of claims 1 to 4, further comprising: a diffusion layer disposed on the resin layer; and a light blocking portion having an optical pattern portion between the resin layer and the diffusion layer, and
wherein the optical pattern portion of the light blocking portion has a plurality of concave portions vertically overlapping the light emitting device package.

9. The lighting device of any one of claims 1 to 4, comprising a first reflective layer reflecting light on the resin layer, and
wherein the circuit board, the resin layer, and the first reflective layer include a plurality of convex surfaces protruding with convex curved surfaces on the front side portion of the light emitting device package.

10. The lighting device of any one of claims 1 to 4, wherein the lead frame includes a first lead frame and second and third lead frames on both sides of the first lead frame,
wherein the light emitting chip includes a plurality of light emitting chips mounted in a flip shape on each of the first, second, and third lead frames, and
wherein the frame of the first lead frame includes a groove region in which a top layer is removed between the plurality of light emitting chips.

11. A lighting device comprising:
a circuit board; and
a plurality of light emitting device packages disposed on the circuit board,
wherein each of the light emitting device packages includes:
a body having a first side portion facing the circuit board, a second side portion opposite to the first side portion, third and fourth side portions on both sides of the first and second side portions, and a cavity in which a part of a front side portion is opened;
a plurality of lead frames each having a plurality of frames disposed on a bottom of the cavity and a bonding portion bent from each of the plurality of frames toward the first side portion;
a plurality of light emitting chips electrically connected to the plurality of frames on the bottom of the cavity; and
a molding member in the cavity,
wherein the third side portion and the fourth side portion of the body are disposed in a first direction of the body,
wherein the front and rear side portions of the body are disposed on both sides in a second direction orthogonal to the first direction,
wherein the cavity has a same length as a length of the body in the first direction, and
wherein a length of the molding member is equal to the length of the cavity in the first direction.

12. The lighting device of claim 11, wherein the cavity includes a first reflective supporting portion disposed on any one frame adjacent to the third side portion and a second reflective supporting portion disposed on any other frame adjacent to the fourth side portion, and
wherein the first and second reflective supporting portions are concavely disposed on bottoms of both sides of the cavity in the first direction from the front side portion, and are in contact with the molding member.
